# EUROPÄISCHE PATENTSCHRIFT

(11) **EP 1 122 796 B1**
(45) Veröffentlichungstag und Bekanntmachung des Hinweises auf die Patenterteilung: **05.04.2006**
(21) Anmeldenummer: 01102123.5
(22) Anmeldetag: 31.01.2001
(51) Int. Cl.: H01L 29/78, H01L 21/336

(54) **Vertikales Halbleiterbauelement mit Source-Down-Design und entsprechendes Herstellungsverfahren**
Vertical semiconductor device with a source-down-design and corresponding fabrication process
Dispositif semi-conducteur vertical comportant une connexion source-substrat et procédé de fabrication correspondant

(30) Priorität: 04.02.2000 DE 10004984
(43) Veröffentlichungstag der Anmeldung: 08.08.2001
(73) Patentinhaber: Infineon Technologies AG, 81669 München (DE)
(72) Erfinder: Hirler, Franz, 84424 Isen (DE)
(74) Vertreter: Reinhard - Skuhra - Weise & Partner

(56) Entgegenhaltungen:
- EP-A- 0 440 394
- WO-A-99/36964
- DE-A- 19 638 439

## Beschreibung

Die vorliegende Erfindung betrifft ein vertikales Halbleiterbauelement mit Source-Down-Design sowie ein entsprechendes Herstellungsverfahren.

Die DE 196 38 439 A1 offenbart ein durch Feldeffekt steuerbares, vertikales Halbleiterbauelement, bestehend aus einem Halbleiterkörper mit mindestens einem Draingebiet vom ersten Leitungstyp, mindestens einem Sourcegebiet vom ersten Leitungstyp, mindestens einem Bodygebiet vom zweiten Leitungstyp zwischen Drain- und Sourcegebiet und mindestens einer Gateelektrode, die gegenüber dem gesamten Halbleiterkörper durch ein Gateoxid isoliert ist, wobei sich der Gateanschluß und Drainanschluß auf der Scheibenvorderseite und der Sourceanschluß auf der Scheiebenrückseite befindet.

Die EP-A-0 440 394 offenbart einen vertikalen MOSFET-Transistor mit einem Halbleitersubstrat mit einer ersten und einer zweiten Oberfläche, einem Drainbereich an der ersten Oberfläche, einem kanalbildenden Bereich unter dem Drainbereich, einem Sourcebereich unter dem kanalbildenden Bereich, einem Gatedielektrikum mit einer Gateelektrode, die auf einem Teilbereich des kanalbildenden Bereichs zwischen Source und Drain ausgebildet sind um die Leitfähigkeit dazwischen zu beeinflussen, und einem vergrabenen ohmschen Kontakt, der einen Teil des kanalbildenden Bereichs mit dem darunter liegenden Sourcebereich kurzschließt.

Die WO-A-99/36964 offenbart einen FET mit Source-Substratanschluss und vergrabenem Gate, wobei eine Drainzone eines ersten Leitungstyps an einer Oberfläche einer auf einem Halbleitersubstrat des ersten Leitungstyps angeordneten Halbleiterschicht des ersten Leitungstyps vorgesehen ist, ein Graben-Gate im wesentlichen die Halbleiterschicht durchsetzt, am Ende des Grabens an der anderen Oberfläche der Halbleiterschicht eine Sourcezone des ersten Leitungstyps vorgesehen ist, im Gebiet neben dem Graben an der anderen Oberfläche der Halbleiterschicht eine Halbleiterzone eines zweiten Leitungstyps vorgesehen ist, deren Oberfläche zusammen mit der Oberfläche der Sourcezone die andere Oberfläche der Halbleiterschicht bildet, und eine vergrabene hochleitende Schicht zwischen der anderen Oberfläche der Halbleiterschicht und dem Halbleitersubstrat vorgesehen ist.

Obwohl auf beliebige Halbleiterbauelemente anwendbar, werden die vorliegende Erfindung sowie die ihr zu Grunde liegende Problematik in Bezug auf vertikale Source-Down-Leistungstransistoren erläutert.

Source-Down-Leistungstransistoren bieten als Einzelschalter sowie als integrierte Merhfachschalter (mit Common Source = gemeinsamer Sourceanschluss) Vorteile schaltungstechnischer und thermischer Art.

Ein Problem bei ihrer Herstellung besteht darin, dass das Sourcegebiet und das Bodygebiet, welche im Silizium vergraben sind, kurzgeschlossen sein müssen, damit der parasitäre Biopolartransistor nicht einschaltet.

Daher ist es Aufgabe der vorliegenden Erfindung, ein Halbleiterbauelement der eingangs genannten Art bereitzustellen, bei dem der Kurzschluß zwischen Sourcegebiet und Bodygebiet prozeßtechnisch günstig herstellbar ist. Eine weitere Aufgabe besteht in der Bereitstellung eines entsprechenden Herstellungsverfahrens.

Erfindungsgemäß wird diese Aufgabe durch das in Anspruch 1 angegebene Halbleiterbauelement bzw. durch das in Anspruch 7 angegebene Herstellungsverfahren gelöst.

Die der vorliegenden Erfindung zugrundeliegende Idee besteht darin, daß das Halbleiterbauelement als Trenchbauelement (Trench = Graben) realisiert wird, wobei der Trench die Gateelektrode enthält. Der Kurzschluß zwischen Bodygebiet und Sourcegebiet ist im unteren Bereich des Trenchs realisiert, wobei nicht das Substrat, sondern ein zusätzlicher, vorzugsweise implantierter Bereich als Sourcebereich dient, welcher mit dem Substrat und dem Bodybereich beispielsweise über ein Silizid kurzgeschlossen ist.

Dabei ist es zweckmäßig, eine Prozeßfolge vorzusehen, die eine Isolation des Gates vom Kurzschluß zwischen Bodygebiet und Sourcegebiet sowie eine dickere Isolation im oberen Teil des Trenches zur Isolation zwischen Drain und Gate schafft.

Ein Vorteil der erfindungsgemäßen Ausgestaltung besteht darin, daß der Kurzschluß zwischen Bodygebiet und Sourcegebiet platzsparend im unteren Bereich des Trenchs realisiert ist.

In den Unteransprüchen finden sich vorteilhafte Weiterbildungen und Verbesserungen des in Anspruch 1 angegebenen Halbleiterbauelements bzw. des in Anspruch 7 angegebenen Herstellungsverfahrens.

Gemäß einer bevorzugten Weiterbildung ist mindestens eine der ersten, zweiten und dritten Schicht eine Epitaxieschicht.

Gemäß einer weiteren bevorzugten Weiterbildung ist der Sourcebereich ein Implantationsbereich.

Gemäß einer weiteren bevorzugten Weiterbildung ist die leitende Schicht eine Silizidschicht.

Gemäß einer weiteren bevorzugten Weiterbildung wird die Silizidschicht durch Abscheiden von einem Metall, vorzugsweise Wolfram, in dem Graben und thermisches Silizidieren geschaffen.

Gemäß einer weiteren bevorzugten Weiterbildung ist der erste Leitungstyp der n-Leitungstyp.

Gemäß einer weiteren bevorzugten Weiterbildung wird die zweite Schicht durch eine Implantation in den Trenchboden und eine Ausdiffusion vor der Sourceimplantation gebildet.

Ausführungsbeispiele der Erfindung sind in den Zeichnungen dargestellt und in der nachfolgenden Beschreibung näher erläutert.

Es zeigen:
- Fig. 1: eine schematische Darstellung eines Halbleiterbauelements als Ausführungsform der vorliegenden Erfindung; und
- Fig. 2a-e: eine schematische Darstellung der wesentlichen Verfahrensschritte zur Herstellung des Halbleiterbauelements nach Fig. 1.

In den Figuren bezeichnen gleiche Bezugszeichen gleiche oder funktionsgleiche Elemente.

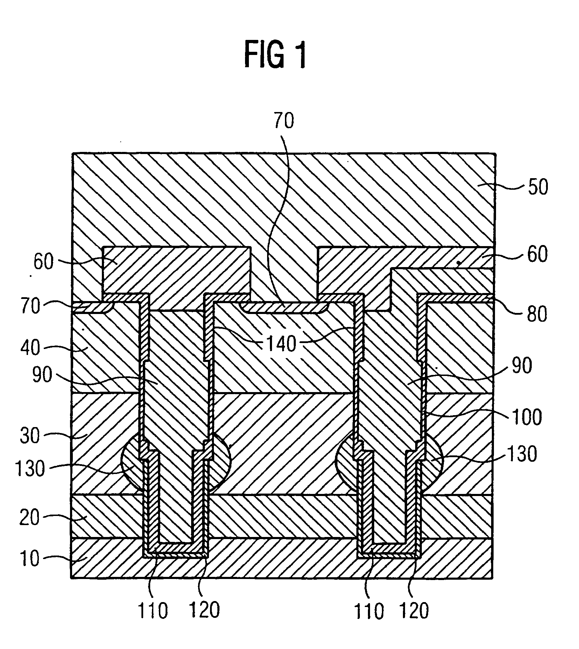

Fig. 1 ist eine schematische Darstellung eines Halbleiterbauelements als Ausführungsform der vorliegenden Erfindung.

In Fig. 1 bezeichnen 10 ein n⁺-Substrat, 20 eine p⁺-Epitaxieschicht (Bodyanschluß), 30 eine p-Epitaxieschicht (Body), 40 eine n-Epitaxieschicht (Drain), 50 einen Drainanschluß, 60 einen Isolationsbereich, 70 einen Drainkontakt, 80 eine erste Isolationsschicht, 90 ein Gate, 100 ein Gateoxid, 110 eine zweite Isolationsschicht, 120 einen Silizidbereich, 130 einen Sourcebereich und 140 einen Graben.

Bei dieser Ausführungsform handelt es sich um einen Soürce-Down-Leistungstransistor mit einem Substrat des n⁺-Leitungstyps.

Eine erste, zweite und dritte Epitaxiechicht 20, 30, 40 sind auf dem n⁺-Substrat 10 vorgesehen, nämlich die erste Schicht 20 des p⁺-Leitungstyps auf dem Substrat 10 als Bodyanschlußbereich, die zweite Schicht 30 des p-Leitungstyps auf der ersten Schicht 20 als Bodybereich und die dritte Schicht 40 des n-Leitungstyps n auf der zweiten Schicht 30 als Drainbereich.

Der Graben 140, welcher bis zum Substrat 10 hinunter reicht, enthält eine Gatestruktur 90, 100 mit einem Gate 90 und einem Gateoxid 100, wobei das Gate 100 durch die Isolationsschichten 90 und 110 sowie den Isolationsbereich 60 von seiner Umgebung isoliert ist.

In der zweiten Schicht 30 in der Peripherie des Grabens 140 vorgesehen ist der Sourcebereich 130 des n⁺-Leitungstyps, der ein Implantationsbereich ist. Der Sourcebereich 130 ist durch eine im unteren Grabenbereich vorgesehene leitende Schicht 120 in Form einer Silizidschicht mit der ersten Schicht 20 und dem Substrat 10 kurzgeschlossen.

In Fig. 1 sind zwei solche Transistoren gezeigt, wobei der rechte Transistor ein nach rechts außen hin angeschlossenes bzw. verschaltetes Gate 90 aufweist und der linke Transistor ein durch einen nicht dargestellten Quertrench nach hinten (dritte Dimension) hin angeschlossenes bzw. verschaltetes Gate 90 aufweist.

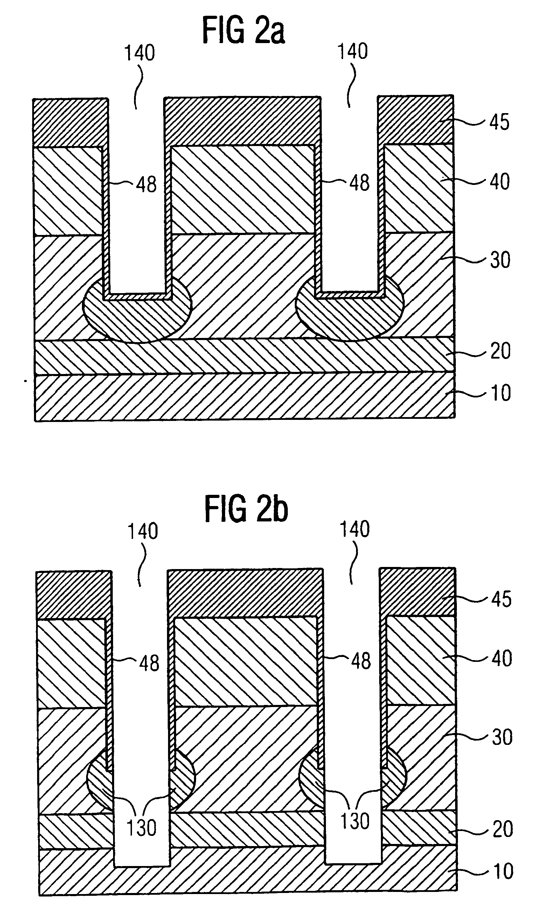

Fig. 2a-f sind schematische Darstellungen der wesentlichen Verfahrensschritte zur Herstellung des Halbleiterbauelements nach Fig. 1.

Gemäß Fig. 2a erfolgt ein Bereitstellen des n⁺-Substrats 10 und danach ein epitaktisches Bilden der ersten Schicht 20 des Leitungstyps p⁺ auf dem Substrat 10, der zweiten Schicht 30 des Leitungstyps p auf der ersten Schicht 20 und der dritten Schicht 40 des Leitungstyps n auf der zweiten Schicht 30.

Darauf wird ein Oxid 45 abgeschieden und ein Graben 140, welcher bis zur zweiten Schicht 20 hinunter reicht, gebildet. Letzteres erfolgt durch Bilden einer Photomaske auf dem Oxid 45 und eine anisotrope Ätzung des Oxids 45 (Hartmaske) und des Trenchs. Anschließend wird im Graben 140 ein Streuoxid 48 gebildet. Danach erfolgt das Implantieren und Diffundieren des Sourcebereichs 130 des Leitungstyps n⁺ im unteren Teil der zweiten Schicht 30 in der Peripherie des Grabens 140.

Durch eine weitere anisotrope Ätzung erfolgt dann ein Vertiefen des Grabens 140 bis hinunter zum Substrat 10, wie in Fig. 2b illustriert.

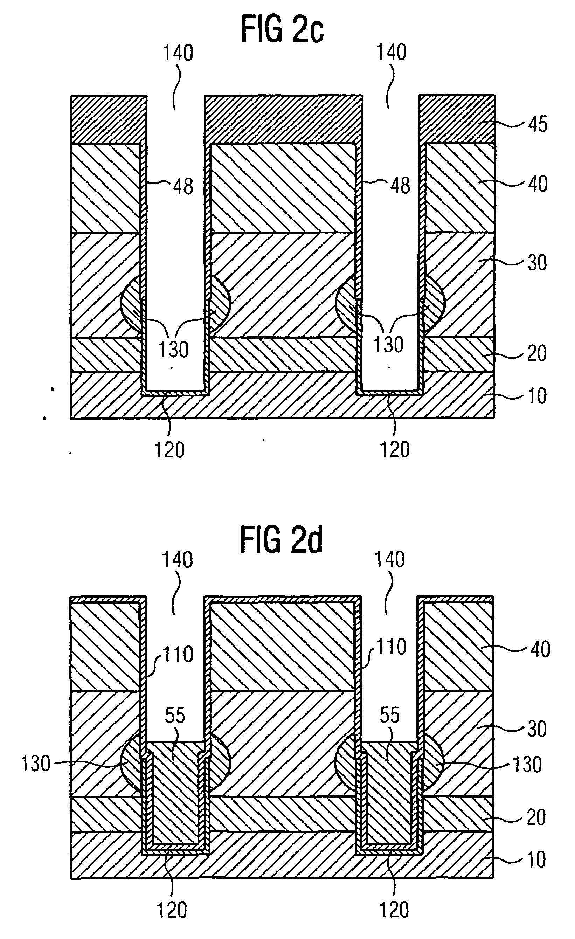

Als nächstes erfolgt gemäß Fig. 2c ein Kurzschließen des Sourcebereichs 130 durch Ausbilden der leitenden Schicht 120 im unteren Grabenbereich mit der ersten Schicht 20 und dem Substrat 10. Hierzu wird ein Metall, z.B. Wolfram, durch eine konforme Abscheidung im Graben gebildet und im unteren Bereich, wo es auf dem Silizium liegt (also unterhalb des verbleibenden Streuoxids 48) durch eine thermische Reaktion in die leitende Schicht 120 aus Silizid umgewandelt. Durch eine anschließende Ätzung wird das restliche, auf Oxid befindliche Metall entfernt.

Gemäß Fig. 2d erfolgt dann das Abscheiden von Oxid 110, das Aufbringen von einer Hilfsschicht 55 und das Rückätzen der Hilfsschicht 55.

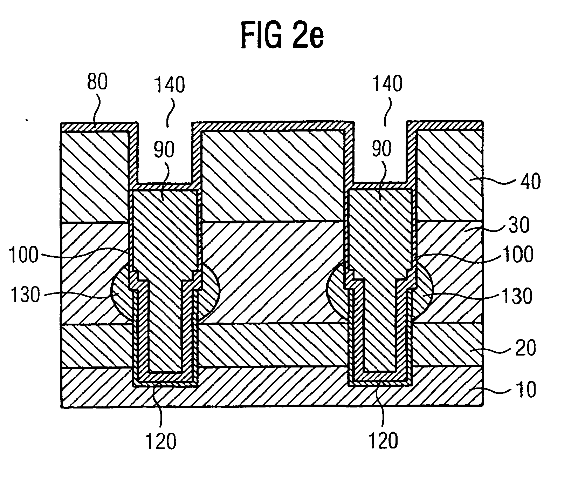

Wie in Fig. 2e gezeigt, wird das Oxid 110 im Bereich oberhalb der verbleibenden Hilfsschicht 55 geätzt und ein Gate- oxid 100 gebildet. Dann wird die Hilfsschicht 55 entfernt und Gate-Polysilizium über der resultierenden Struktur abgeschieden. Das Gate-Polysilizium wird ggfs. dotiert und dann zurückgeätzt.

Dann wird, falls zur Isolation notwendig, ein dickeres Oxid 80 analog zum Oxid 110 im oberen Bereich des Grabens thermisch oder durch Abscheidung gebildet.

Um zur Struktur von Fig. 1 zu gelangen erfolgen danach eine anisotrope Ätzung des Oxids 80, um es von der Oberseite des Gate-Polysiliziums 90 zu entfernen und anschließend eine erneute Abscheidung, Dotierung und Rückätzung weiteren Gate-Polysiliziums 90. Mittels Bor-Phosphor-Silikatglas (BPSG) wird schließlich der Isolationsbereich 60 an der Trenchoberseite gebildet. Mittels einer Maske werden Kontaktlöcher für den Drainanschluß gebildet und der Drainkontakt 70 selbstjustierend implantiert. Schließlich erfolgt die Bildung der Metallebene für den Drainanschluß 50 zur Vervollständigung des Transistors.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar im Rahmen des beanspruchten Gegenstandes.

Insbesondere wird in einer weiteren bevorzugten Ausführungsform der Body nicht durch eine Epitaxieschicht realisiert, sondern durch eine p-Implantation in den Trenchboden und eine Ausdiffusion vor der Sourceimplantation.

Auch ist die vorliegende Erfindung nicht auf dem geschilderten Transistor beschränkt, sondern kann auf eine beliebige kompliziertere Struktur, z.B. eine Thyristorstruktur angewendet werden.

Weiterhin ist der Bodyanschlußbereich nicht zwingend erforderlich, sondern es ist auch möglich, den Bodybereich direkt anzuschließen.

## Patentansprüche

1. Halbleiterbauelement mit:
einem Substrat (10) eines ersten Leitungstyps (n⁺);
einer oberhalb des Substrats (10) vorgesehenen zweiten Schicht (30) des Leitungstyps (p) als Bodybereich;
einer auf der zweiten Schicht (30) vorgesehenen dritten Schicht(40) des ersten Leitungstyps (n) als Drainbereich; einem Graben (140), welcher bis zum Substrat (10) hinunter reicht;
einer in dem Graben (140) vorgesehenen Gatestruktur (90, 100); und
einem in der zweiten Schicht (30) in der Peripherie des Grabens (140) vorgesehenen Sourcebereich (130) des ersten Leitungstyps (n⁺);
wobei der Sourcebereich (130) durch eine im unteren Grabenbereich vorgesehene leitende Schicht (120) mit der zweiten Schiht (30) und dem Substrat (10) kurzgeschlossen ist.

2. Halbleiterbauelement nach Anspruch 1,
**dadurch gekennzeichnet,**
**dass** auf dem Substrat (10) eine erste Schicht (20) des zweiten Leitungstyps (p+) als Bodyanschlussbereich vorgesehen ist, auf welcher die zweite Schicht vorgesehen ist.

3. Halbleiterbauelement nach Anspruch 2,
**dadurch gekennzeichnet,**
**dass** mindestens eine der ersten, zweiten und dritten Schicht (20, 30, 40) eine Epitaxieschicht ist.

4. Halbleiterbauelement nach einem der vorhergehenden Ansprüche,
**dadurch gekennzeichnet,**
**dass** der Sourcebereich (130) ein Implantationsbereich ist.

5. Halbleiterbauelement nach einem der vorhergehenden Ansprüche,
**dadurch gekennzeichnet,**
**dass** die leitende Schicht (120) eine Silizidschicht ist.

6. Halbleiterbauelement nach einem der vorhergehenden Ansprüche,
**dadurch gekennzeichnet,**
**dass** der erste Leitungstyp der n-Leitungstyp ist.

7. Verfahren zur Herstellung eines Halbleiterbauelements mit den Schritten:
Bereitstellen von einem Substrat (10) eines ersten Leitungstyps (n⁺);
Vorsehen einer zweiten Schicht (30) des zweiten Leitungstyps (p) oberhalb des Substrats (10);
Vorsehen einer dritten Schicht (40) des ersten Leitungstyps (n) auf der zweiten Schicht (30);
Bilden eines Grabens (140), welcher bis zur zweiten Schicht (20) hinunter reicht;
Bilden eines Sourcebereichs (130) des ersten Leitungstyps (n⁺) im unteren Teil der zweiten Schicht (30) in der Peripherie des Grabens (140);
Vertiefen des Grabens (140) bis hinunter zum Substrat (10); Kurzschließen des Sourcebereichs (130) mit der zweiten Schicht (30) und dem Substrat (10) durch Ausbilden einer leitenden Schicht (120) im unterem Grabenbereich; und
Bilden einer Gatestruktur (90, 100) in dem Graben (140).

8. Verfahren nach Anspruch 8,
**dadurch gekennzeichnet,**
**dass** auf dem Substrat (10) eine erste Schicht (20) des zweiten Leitungstyps (p+) vorgesehen wird, auf welcher die zweite Schicht vorgesehen wird.

9. Verfahren nach Anspruch 8,
**dadurch gekennzeichnet,**
**dass** mindestens eine der ersten, zweiten und dritten Schicht (20, 30, 40) epitaktisch abgeschieden wird.

10. Verfahren nach einem der vorhergehenden Ansprüche 7 bis 9,
**dadurch gekennzeichnet,**
**dass** der Sourcebereich (130) implantiert wird.

11. Verfahren nach einem der vorhergehenden Ansprüche 7 bis 10,
**dadurch gekennzeichnet,**
**dass** die leitende Schicht (120) eine Silizidschicht ist, welche durch Abscheiden von einem Metall, vorzugsweise Wolfram, in dem Graben (140) und thermisches Silizidieren geschaffen wird.

12. Verfahren nach einem der vorhergehenden Ansprüche 7 bis 11,
**dadurch gekennzeichnet,**
**dass** der erste Leitungstyp der n-Leitungstyp ist.

13. Verfahren nach einem der vorhergehenden Ansprüche 7 bis 11,
**dadurch gekennzeichnet,**
**dass** die zweite Schicht (30) durch eine Implantation in den Trenchboden und eine Ausdiffusion vor der Sourceimplantation gebildet wird.

## Claims

1. Semiconductor component having:
a substrate (10) of a first conduction type (n⁺);
provided above the substrate (10), a second layer (30) of the conduction type (p) as body region;
provided on the second layer (30), a third layer (40) of the first conduction type (n) as drain region;
a trench (140) reaching down to the substrate (10);
a gate structure (90, 100) provided in the trench (140); and
a source region (130) of the first conduction type (n⁺), said source region being provided in the second layer (30) in the periphery of the trench (140);
the source region (130) being short-circuited with the second layer (30) and the substrate (10) by a conductive layer (120) provided in the lower region of the trench.

2. Semiconductor component according to Claim 1,
**characterized**
**In that** a first layer (20) of the second conduction type (p⁺) is provided as body connection region on the substrate (10), on which layer the second layer is provided.

3. Semiconductor component according to Claim 2,
**characterized**
**in that** at least one of the first, second and third layers (20, 30, 40) is an epitaxial layer.

4. Semiconductor component according to one of the preceding claims,
**characterized**
**in that** the source region (130) is an implantation region.

5. Semiconductor component according to one of the preceding claims,
**characterized**
**in that** the conductive layer (120) is a silicide layer.

6. Semiconductor component according to one of the preceding claims,
**characterized**
**in that** the first conduction type is the n conduction type.

7. Method for fabricating a semiconductor component having the steps of:
providing a substrate (10) of a first conduction type (n⁺) ;
providing a second layer (30) of the second conduction type (p) above the substrate (10);
providing a third layer (40) of the first conduction type (n) on the second layer (30);
forming a trench (140) reaching down to the second layer (20);
forming a source region (130) of the first conduction type (n⁺) in the lower part of the second layer (30) in the periphery of the trench (140);
deepening the trench (140) down to the substrate (10);
short-circuiting the source region (130) with the second layer (30) and the substrate (10) by forming a conductive layer (120) in the lower region of the trench; and
forming a gate structure (90, 100) in the trench (140).

8. Method according to Claim 7,
**characterized**
**in that** a first layer (20) of the second conduction type (p⁺) is provided on the substrate (10), on which layer the second layer is provided.

9. Method according to Claim 8,
**characterized**
**in that** at least one of the first, second and third layers (20, 30, 40) is deposited epitaxially.

10. Method according to one of the preceding Claims 7 to 9,
**characterized**
**in that** the source region (130) is implanted.

11. Method according to one of the preceding Claims 7 to 10,
**characterized**
**in that** the conductive layer (120) is a silicide layer produced by depositing a metal, preferably tungsten, in the trench (140) and thermal siliciding.

12. Method according to one of the preceding Claims 7 to 9,
**characterized**
**in that** the first conduction type is the n conduction type.

13. The method according to one of the preceding Claims 7 to 11,
**characterized**
**in that** the second layer (30) is formed by implantation into the bottom of the trench and outdiffusion prior to the source implantation.

## Revendications

1. Composant semi-conducteur comprenant :
un substrat (10) d'une première nature de conductivité (n⁺) ;
une deuxième couche (30) de nature de conductivité (p), prévue au-dessus du substrat (10), comme région de body ;
une troisième couche (40) de la première nature de conductivité (n), prévue sur la deuxième couche (30), comme région de drain ;
une tranchée (140) qui arrive jusqu'au substrat (10) ;
une structure de grille (90, 100) prévue dans la tranchée (140) ; et
une région de source (130) de la première nature de conductivité (n⁺), prévue dans la deuxième couche (30) dans la périphérie de la tranchée (140) ;
la région de source (130) étant court-circuitée avec la deuxième couche (30) et le substrat (10) par une couche (120) conductrice prévue dans la région inférieure de la tranchée.

2. Composant semi-conducteur selon la revendication 1,
**caractérisé en ce que** sur le substrat (10), une première couche (20) de la deuxième nature de conductivité (p+) est prévue comme région de connexion de body sur laquelle la deuxième couche est prévue.

3. Composant semi-conducteur selon la revendication 2,
**caractérisé en ce qu'**au moins une de la première, deuxième et troisième couche (20, 30, 40) est une couche épitaxiale.

4. Composant semi-conducteur selon l'une quelconque des revendications précédentes,
**caractérisé en ce que** la région de source (130) est une région d'implantation.

5. Composant semi-conducteur selon l'une quelconque des revendications précédentes,
**caractérisé en ce que** la couche conductrice (120) est une couche silicide.

6. Composant semi-conducteur selon l'une quelconque des revendications précédentes,
**caractérisé en ce que** la première nature de conductivité est de type n.

7. Procédé pour la fabrication d'un composant semi-conducteur comprenant les étapes :
mise à disposition d'un substrat (10) d'une première nature de conductivité (n⁺) ;
prévision d'une deuxième couche (30) de la deuxième nature de conductivité (p) au dessus du substrat (10) ;
prévision d'une troisième couche (40) de la première nature de conductivité (n) sur la deuxième couche (30) ;
formation d'une tranchée (140) qui arrive jusqu'à la deuxième couche (20);
formation d'une région de source (130) de la première nature de conductivité (n⁺) dans la partie inférieure de la deuxième couche (30) dans la périphérie de la tranchée (140) ;
approfondissement de la tranchée (140) jusqu'au substrat (10) ;
mise en court-circuit de la région de source (130) avec la deuxième couche (30) et le substrat (10) par la formation d'une couche (120) conductrice dans la région inférieure de la tranchée ; et
formation d'une structure de grille (90, 100) dans la tranchée (140).

8. Procédé selon la revendication 8,
**caractérisé en ce qu'**on prévoit, sur le substrat (10), une première couche (20) de la deuxième nature conductrice (p+) sur laquelle la deuxième couche est prévue.

9. Procédé selon la revendication 8,
**caractérisé en ce qu'**au moins une de la première, deuxième et troisième couche (20, 30, 40) est déposée de façon épitaxiale.

10. Procédé selon l'une quelconque des revendications précédentes 7 à 9,
**caractérisé par** en ce que la région de source (130) est implantée.

11. Procédé selon l'une quelconque des revendications précédentes 7 à 10,
**caractérisé en ce que** la couche conductrice (120) est une couche silicide qui est réalisée par déposition d'un métal, de préférence du tungstène, dans la tranchée (140) et par une silicidation thermique.

12. Procédé selon l'une quelconque des revendications précédentes 7 à 11,
**caractérisé en ce que** la première nature de conductivité est de type n.

13. Procédé selon l'une quelconque des revendications précédentes 7 à 11,
**caractérisé en ce que** la deuxième couche (30) est formée par une implantation dans le fond de la tranchée et une diffusion avant l'implantation de la source.
